(19) Europäisches Patentamt
European Patent Office
Office européen des brevets

(11) **EP 2 279 524 B1**

(12) **FASCICULE DE BREVET EUROPEEN**

(45) Date de publication et mention
de la délivrance du brevet:
**19.09.2018 Bulletin 2018/38**

(21) Numéro de dépôt: **09749817.4**

(22) Date de dépôt: **19.05.2009**

(51) Int Cl.:
**H01L 27/146** *(2006.01)*    **H01L 31/0203** *(2014.01)*
**H01L 31/0232** *(2014.01)*    **H04N 5/225** *(2006.01)*
**G02B 13/00** *(2006.01)*

(86) Numéro de dépôt international:
**PCT/EP2009/056040**

(87) Numéro de publication internationale:
**WO 2009/141327 (26.11.2009 Gazette 2009/48)**

(54) **PROCEDE DE REALISATION D'UN DISPOSITIF OPTIQUE A COMPOSANTS OPTOELECTRONIQUES INTEGRES**

VERFAHREN ZUR HERSTELLUNG EINER OPTISCHEN VORRICHTUNG AUS INTEGRIERTEN OPTOELEKTRONISCHEN KOMPONENTEN

METHOD OF PRODUCING AN OPTICAL DEVICE CONSISTING OF INTEGRATED OPTOELECTRONIC COMPONENTS

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **21.05.2008 FR 0853293**

(43) Date de publication de la demande:
**02.02.2011 Bulletin 2011/05**

(73) Titulaire: **Commissariat à l'Énergie Atomique et aux Énergies Alternatives**
**75015 Paris (FR)**

(72) Inventeur: **BOLIS, Sébastien**
**F-38920 Crolles (FR)**

(74) Mandataire: **Ilgart, Jean-Christophe**
**BREVALEX**
**95, rue d'Amsterdam**
**75378 Paris Cedex 8 (FR)**

(56) Documents cités:
**EP-A- 1 772 908        EP-A- 1 811 772**
**WO-A-2004/027880        WO-A-2008/011003**
**US-A- 5 604 160         US-A- 5 915 168**
**US-A1- 2005 184 219     US-A1- 2005 275 750**
**US-A1- 2006 043 262     US-A1- 2007 187 789**
**US-B1- 6 669 803**

## Description

## DOMAINE TECHNIQUE

L'invention concerne un procédé de réalisation d'un dispositif optique à composants optoélectroniques intégrés comportant une structure de protection (« waferlevel packaging » en anglais) des composants optoélectroniques intégrés, par exemple des imageurs CMOS (« Complementary Metal Oxide Semiconductor ») ou CCD (« Charge Coupled Device »).

L'invention s'applique à tout type d'imageurs, quelle que soit la gamme de longueur d'onde de détection de ces imageurs (domaine visible, infrarouge, ...). Le dispositif optique réalisé peut avantageusement être une caméra à imageurs intégrés.

## ÉTAT DE LA TECHNIQUE ANTÉRIEURE

Dans le domaine des structures de protection de substrats à imageurs intégrés, un système connu de poignée mécanique est utilisé lorsqu'un tel substrat doit être aminci à une faible épaisseur et subir éventuellement d'autres opérations technologiques. On entend par faible épaisseur une épaisseur en deçà de laquelle le substrat ne présente plus une tenue mécanique suffisante pour garantir sa manipulation sans risque d'endommagement, réaliser son chargement automatique dans des équipements et permettre la réalisation d'opérations technologiques à l'échelle du substrat sans une telle poignée mécanique. Une telle épaisseur qualifiée de faible peut être comprise entre environ 300 µm et quelques micromètres.

Lorsqu'une telle poignée mécanique est utilisée pour un substrat comportant des imageurs intégrés, cette poignée est typiquement réalisée par un substrat à base de verre qui est reporté sur le substrat comportant les imageurs.

L'utilisation d'une telle poignée mécanique présente toutefois des inconvénients. En effet, étant donné que le coefficient de dilatation thermique (CTE) du verre, qui est par exemple égale à 3,3 m/m/K pour du verre borofloat, est différent de celui du silicium (typiquement égale à 2,6 m/m/K), la structure formée par la poignée mécanique et le substrat après collage présente une déformation qui peut être problématique non seulement pour la manipulation automatique du substrat mais aussi pour la qualité des opérations que doit subir ultérieurement cette structure. Cette déformation est d'autant plus problématique que la taille des substrats est grande (par exemple dans le cas de wafer de 12 pouces). De plus, dans la perspective d'ajouter des fonctions au substrat de verre, il peut être avantageux d'utiliser des verres à plus grand coefficient de dilatation thermique, entraînant une déformation encore plus importante de la structure. La problématique détaillée ci-dessus liée à la déformation de la structure formée devient alors très vite limitante et bloquante.

Lorsqu'une telle poignée est collée à un substrat comportant des imageurs, la structure formée par le substrat et la poignée mécanique est découpée, après la réalisation de diverses opérations technologiques sur le substrat, afin de former des éléments indépendants comportant chacun un imageur, chaque élément étant ensuite reporté dans un module caméra comprenant d'autres éléments optiques.

Il est également connu de réaliser un module caméra comportant une structure de protection d'un substrat, appelée interposeur, réalisant une interface entre le substrat et des éléments optiques (par exemple une simple lame de verre ou bien un ensemble comportant une ou plusieurs lentilles). Un tel interposeur est disposé sur le substrat comportant les imageurs et permet de positionner les éléments optiques à une distance précise par rapport au plan pixels, c'est-à-dire le plan à partir duquel est réalisée une détection lumineuse par les imageurs, et de former une cavité d'air, ou d'atmosphère contrôlée, au dessus du plan pixels afin d'optimiser les performances optiques du module caméra.

L'intérêt d'un tel interposeur est de pouvoir maîtriser, à l'échelle du substrat, la distance élément optique - imageur et de s'affranchir ainsi de l'opération de mise au point des modules caméra qui ne comportent pas de tels interposeurs, consistant à placer le plan pixels de l'imageur dans le plan focal de l'élément optique, qui est une opération coûteuse.

Le document US 7 223 626 B2 décrit un interposeur formant une matrice à base d'un matériau polymérisé comportant des évidements, ces évidements étant destinés à être disposés au-dessus des imageurs intégrés à un substrat. Après que l'interposeur soit disposé sur le substrat comportant les imageurs, un substrat de verre est reporté sur l'interposeur. Cet interposeur permet d'obtenir un positionnement précis du substrat de verre par rapport au substrat à imageurs.

L'utilisation d'un tel interposeur a notamment pour inconvénient que la référence mécanique pour le report d'éléments optiques autres que le substrat de verre destinés à être couplés optiquement aux imageurs est la face supérieure du substrat de verre, c'est-à-dire la face opposée à celle en contact avec l'interposeur. Ainsi, la maîtrise de la distance entre ces autres éléments optiques et les imageurs nécessite la maîtrise d'une chaîne de cotes assez complexe. En effet, la maîtrise de la position de la référence mécanique par rapport aux imageurs implique la maîtrise de l'épaisseur de l'interposeur, de l'épaisseur du substrat de verre et des épaisseurs des différents joints de colle requis entre ces éléments. Cette chaîne de cotes représente donc une source d'erreurs potentielles importantes.

De plus, les coefficients de dilatation thermique des matériaux constitutifs de cette structure (epoxy, polyimide, etc.) diffèrent fortement de celui du silicium (matériau du substrat comportant les imageurs). Si des opérations technologiques de type waferlevel (dépôts CVD, PVD, etc.) sont envisagées, la déformation résultante du collage de l'ensemble peut alors être problématique.

Les documents US 2006/035415 A1 et US 2006/043262 A1 décrivent des interposeurs ajourés recevant différents éléments optiques dans leurs ouvertures. De tels interposeurs sont utilisés lors des opérations finales de packaging des imageurs car ils ne peuvent pas servir de poignée mécanique. De plus, de tels interposeurs ne permettent pas de réaliser un amincissement du substrat tout en garantissant à l'ensemble ainsi constitué une facilité de manipulation et une compatibilité avec les procédés standards réalisés à l'échelle du substrat. Les opérations technologiques à réaliser sur les dispositifs, et plus particulièrement sur les substrats à imageurs comportant ces interposeurs, sont délicates du fait de la structuration ajourée des interposeurs et de l'hétérogénéité de la face opposée au plan image qui fragilisent les dispositifs et compliquent le maintien du substrat par aspiration et éventuellement le chauffage du substrat à imageurs lors d'étapes technologiques ultérieures. Enfin, étant donné que de nombreux éléments sont utilisés pour réaliser le dispositif, la chaîne de cotes à maîtriser est également complexe pour positionner correctement un élément optique supplémentaire vis-à-vis d'un imageur.

Le document US 7 144 745 B2 décrit une structure mixte pouvant servir à la fois d'interposeur et de poignée mécanique. Mais là encore, cette structure a pour inconvénient que la référence mécanique pour le report d'éléments optiques est la face supérieure d'un substrat de verre, impliquant une maîtrise d'une chaîne de cotes complexe. De plus, le coefficient de dilatation thermique des matériaux utilisés diffère de celui du silicium à partir duquel est constitué le substrat à imageurs, impliquant des déformations problématiques du dispositif comportant cette structure.

Le document US 5 915 168 décrit un procédé de réalisation d'un dispositif optique à composant optoélectronique intégré avec une solidarisation du support à un substrat.

Le document US 2005 275750 A1 décrit un amincissement d'un substrat et la réalisation d'interconnexions à travers le substrat.

## EXPOSÉ DE L'INVENTION

Un but de la présente invention est de proposer un procédé de réalisation d'un dispositif optique ne comportant pas les inconvénients de l'art antérieur, c'est-à-dire faisant appel à une structure de protection remplissant à la fois les rôles d'interposeur et de poignée mécanique au cours d'opérations technologiques réalisées sur un substrat comportant des composants optoélectroniques intégrés, ne posant pas de problèmes de dilatation thermique entre la structure de protection et le substrat comportant les imageurs et n'impliquant de chaine de cotes complexe lors d'un éventuel ajout d'éléments optiques supplémentaires.

Pour cela, il est proposé un procédé de réalisation d'un dispositif optique à composants optoélectroniques intégrés, comportant au moins les étapes de :

a) réalisation d'une structure de protection comprenant au moins un support dans lequel est réalisé au moins un trou borgne, au moins un élément optique étant disposé dans le trou borgne et solidarisé avec au moins une paroi du trou borgne,
b) solidarisation du support à un substrat comprenant les composants optoélectroniques intégrés, le trou borgne formant une cavité dans laquelle l'élément optique fait face à un des composants optoélectroniques,
c) réalisation de connexions électriques à travers le substrat et/ou entre le substrat et le support et/ou à travers le support, et/ou réalisation d'un amincissement du substrat et/ou du support,
d) réalisation d'au moins une ouverture à travers la paroi de fond du trou borgne, mettant à nu au moins une partie de l'élément optique ou découvrant au moins une partie du champ optique de l'élément optique.

L'étape c) peut comporter la réalisation d'un amincissement du substrat et la réalisation de connexions électriques à travers le substrat.

Dans ce cas, l'étape c) peut comporter en outre la réalisation de connexions électriques entre le substrat et le support et/ou à travers le support, et/ou la réalisation d'un amincissement du support.

Ainsi, la structure de protection remplit à la fois la fonction d'interposeur, c'est-à-dire qu'elle permet de maîtriser la distance entre l'élément optique et le substrat, et la fonction de poignée mécanique, et ne présente pas les inconvénients des structures de l'art antérieur (chaîne de cotes complexe, déformations dues à des coefficients de dilatation thermique différents, difficultés de réalisation d'opérations technologiques ultérieures).

Durant les opérations réalisées au cours de l'étape c) du procédé, la surface de la structure opposée par rapport au plan image, formant la paroi de fond du trou borgne, est non ajourée. Il est donc possible de manipuler le dispositif optique pour réaliser diverses opérations technologiques au cours de l'étape c) (amincissement, dépôt, lithographie, gravure, réalisation d'intraconnexions, etc.) en se servant de la structure de protection comme poignée mécanique.

De plus, en réalisant le support de la structure de protection à partir d'un ou de plusieurs matériaux dont le coefficient de dilatation thermique approche celui du matériau du substrat, le coefficient de dilatation thermique de l'élément optique n'implique plus de déformation dans le dispositif optique étant donné que celui-ci n'est pas en contact direct avec le substrat. Il est donc possible d'utiliser dans la structure de protection des éléments optiques à base de verre à plus fort coefficient de dilatation thermique et/ou envisager un accroissement de la géométrie des substrats, c'est-à-dire utiliser un substrat de plus grandes dimensions.

Lorsque, pour des raisons de performances optiques, la distance entre l'élément optique et l'un des composants optoélectroniques intégrés doit être faible, il est possible d'avoir une référence mécanique, formée par une face arrière du support de la structure de protection (cette face arrière étant la face opposée à celle solidarisé avec le substrat), qui soit éloignée du plan pixels et/ou de l'élément optique car l'épaisseur du support est indépendante de la profondeur du trou borgne réalisé.

L'utilisation d'une telle structure de protection exclut l'incertitude sur l'épaisseur de l'élément optique dans la maitrise de la distance entre l'élément optique et le substrat. Ceci s'applique également dans le cas où d'autres éléments optiques sont reportés ultérieurement sur la structure de protection, étant donné que cette structure nécessite la maîtrise de moins de cotes que les structures de l'art antérieur qui intègrent l'épaisseur de l'élément optique dans leur chaîne de cotes.

Enfin, ce procédé permet de réaliser des connexions électriques à travers le substrat et/ou entre le substrat et le support et/ou à travers le support sans problèmes de manipulation du dispositif grâce à la structure de protection utilisée en tant que poignée mécanique.

La fonction de poignée mécanique peut par exemple être remplie par le support et/ou la structure de protection lorsque le support et/ou la structure de protection ont une épaisseur supérieure ou égale à environ 300 μm, par exemple comprise entre environ 300 μm et 500 μm. Il est notamment possible que l'épaisseur du support soit égale ou supérieure à environ 300 μm, ou comprise entre environ 300 μm et 500 μm après la réalisation d'un amincissement du support. Le substrat peut alors remplir également la fonction de poignée mécanique lors de l'amincissement du support, l'amincissement du substrat pouvant être dans ce cas réalisé après l'amincissement du support. Avant son amincissement, l'épaisseur du substrat peut être supérieure ou égale à environ 300 μm, ou comprise entre environ 300 μm et 500 μm.

Plusieurs éléments optiques peuvent être disposés dans un seul trou borgne du support.

L'élément optique peut être solidarisé à la paroi de fond du trou borgne et/ou à des parois du trou borgne autres que la paroi de fond par au moins une interface de collage.

L'élément optique peut être à base de verre et/ou d'un matériau organique (notamment pour les imageurs fonctionnant dans le domaine visible) et/ou de germanium (pour les détecteurs infrarouge par exemple). L'élément optique peut comporter au moins une lame à faces parallèles et/ou une lentille et/ou une lentille à gradient d'indice.

Le support peut comporter une face arrière, opposée à une face destinée à être solidarisée au substrat, sensiblement plane. Une telle face plane est particulièrement avantageuse pour la réalisation d'opérations technologiques lors de l'étape c) ou après l'étape d) du procédé, par exemple pour réaliser des dépôts de matériaux ou d'éléments optiques sur cette face arrière.

Les composants optoélectroniques intégrés peuvent comporter des imageurs CMOS et/ou CCD. L'invention est particulièrement adaptée pour un substrat à imageurs CMOS intégrés.

Le support peut être à base d'un matériau ayant un coefficient de dilatation thermique sensiblement similaire à celui du matériau du substrat.

Ainsi, selon la nature du matériau du support, celui-ci peut présenter un coefficient de dilatation thermique compatible avec celui du substrat, grâce au fait que la fonction optique soit remplie par l'élément optique et que la fonction de poignée mécanique soit remplie par le support qui est distinct de l'élément optique.

Enfin, lorsque le support est à base d'un matériau similaire à celui du substrat, la découpe de l'ensemble formé par la structure de protection et le substrat est facilitée car cette découpe n'est réalisée que dans le support, par exemple à base de semi-conducteur, et non dans l'élément optique, par exemple à base de verre, comme dans les dispositifs de l'art antérieur faisant appel à un substrat de verre pour réaliser l'élément optique.

Le support peut être solidarisé, au cours de l'étape b) du procédé, au substrat par l'intermédiaire d'éléments espaceurs.

Par ailleurs, l'épaisseur de l'élément optique et la profondeur du trou peuvent être choisies telles que lorsque le support est solidarisé au substrat, la cavité présente entre l'élément optique et le composant optoélectronique intégré peut être remplie d'un fluide particulier si besoin (un gaz ou un liquide). Cette cavité permet également que seul le support de la structure de protection soit en contact avec le substrat. Le matériau du support peut donc être choisi pour éviter les problèmes de dilatation thermique.

L'étape d) peut correspondre à la mise en oeuvre d'un amincissement du support avec arrêt sur l'élément optique.

L'étape a) de réalisation de la structure de protection peut correspondre à la mise en oeuvre des étapes suivantes :

- solidarisation d'une première couche, par exemple à base d'au moins un semi-conducteur, de verre, de LCP (« Liquid Crystal Polymer »), de céramique, d'un matériau organique ou encore de métal, à une seconde couche à base du matériau de l'élément optique,

- gravure de la seconde couche, au moins une portion restante de la seconde couche formant l'élément optique,

- solidarisation d'une troisième couche, par exemple à base d'au moins un semi-conducteur, à une quatrième couche, par exemple à base d'au moins un matériau similaire à celui du substrat comportant les composants optoélectroniques,

- gravure d'au moins un trou à travers la quatrième couche,

- solidarisation de portions restantes de la quatrième couche contre une face de la première couche, l'élément optique étant disposé dans le trou gravé à travers la quatrième couche,
- retrait de la troisième couche.

L'étape a) de réalisation de la structure de protection peut correspondre à la mise en oeuvre des étapes suivantes :

- réalisation d'un premier empilement comportant une première couche mécanique, par exemple à base d'au moins un semi-conducteur, de verre, de LCP (« Liquid Crystal Polymer »), de céramique, d'un matériau organique ou encore de métal, et une seconde couche à base d'au moins un matériau formant l'élément optique,
- gravure de la seconde couche, au moins une portion restante de la seconde couche formant l'élément optique,
- réalisation d'un second empilement comportant une troisième couche, par exemple à base d'au moins un semi-conducteur, et une quatrième couche, par exemple à base d'au moins un matériau similaire à celui du substrat comportant les composants optoélectroniques,
- gravure d'au moins un trou à travers la quatrième couche,
- solidarisation des premier et second empilements, des portions restantes de la quatrième couche étant disposées contre une face de la première couche, l'élément optique étant disposé dans le trou gravé à travers la quatrième couche,
- retrait de la troisième couche.

Le retrait de la troisième couche peut être obtenu par une étape d'amincissement total de la troisième couche ou un démontage de la troisième couche lorsque celle-ci est solidarisée par un collage temporaire à la quatrième couche.

Dans une variante, l'étape a) de réalisation de la structure de protection peut correspondre à la mise en oeuvre des étapes suivantes :

- réalisation d'un collage temporaire entre une première couche, par exemple à base d'au moins un semi-conducteur, de verre, de LCP, de céramique, d'un matériau organique ou encore de métal, et une seconde couche à base du matériau de l'élément optique,
- gravure de la seconde couche, au moins une portion restante de la seconde couche formant l'élément optique,
- dépôt d'une interface de collage au moins sur l'élément optique,
- solidarisation d'une troisième couche, par exemple à base d'au moins un matériau similaire à celui du substrat, comportant les composants optoélectroniques à une quatrième couche, par exemple à base d'au moins un semi-conducteur,
- gravure d'au moins un trou à travers la quatrième couche,
- solidarisation de la troisième couche à l'interface de collage, l'élément optique étant disposé dans le trou gravé à travers la quatrième couche,
- retrait de la première couche.

Dans une variante, l'étape a) de réalisation de la structure de protection peut correspondre à la mise en oeuvre des étapes suivantes :

- réalisation d'un premier empilement comportant une première couche, par exemple à base d'au moins un semi-conducteur, de verre, de LCP, de céramique, d'un matériau organique ou encore de métal, et une seconde couche à base d'au moins un matériau formant l'élément optique,
- gravure de la seconde couche, au moins une portion restante de la seconde couche formant l'élément optique,
- dépôt d'une interface de collage au moins sur l'élément optique,
- réalisation d'un second empilement comportant une troisième couche mécanique, par exemple à base d'au moins un matériau similaire à celui du substrat comportant les composants optoélectroniques, et une quatrième couche, par exemple à base d'au moins un semi-conducteur,
- gravure d'au moins un trou à travers la quatrième couche,
- solidarisation des premier et second empilements, la troisième couche étant disposée contre l'interface de collage, l'élément optique étant disposé dans le trou gravé à travers la quatrième couche,
- retrait de la première couche.

Le report des éléments optiques dans les trous gravés à travers la quatrième couche peut se faire par un report collectif de l'ensemble des éléments optiques, ou de manière individuelle en désolidarisant au préalable les éléments optiques les uns des autres, puis en les reportant individuellement dans les trous gravés. Le report individuel (report de type « Pick and Place ») présente l'avantage de pouvoir trier les éléments optiques et de ne reporter que les éléments optiques souhaités dans les trous gravés.

L'étape a) de réalisation de la structure de protection peut comporter au moins les sous-étapes suivantes :

- réalisation du support dans lequel est réalisé le trou borgne,
- positionnement et solidarisation de l'élément optique dans le trou borgne par l'intermédiaire d'au moins un matériau de fixation préalablement disposé au moins sur une paroi du trou borgne et/ou sur l'élément optique.

Le procédé peut comporter en outre, entre l'étape de gravure du trou à travers la quatrième couche et l'étape de solidarisation de la troisième couche à l'interface de collage, une étape de dépôt d'au moins une couche au moins partiellement opaque dans la gamme des longueurs d'ondes de fonctionnement du composant optoélectronique et/ou électriquement conductrice sur des portions restantes de la quatrième couche et contre des parois du trou gravé à travers la quatrième couche, formant une protection optique et/ou électromagnétique du dispositif.

De manière générale, le procédé peut comporter en outre, au cours de l'étape a), la réalisation d'une protection optique et/ou électromagnétique entre le support et l'élément optique.

Le procédé peut comporter en outre, entre l'étape a) de réalisation de la structure de protection et l'étape b) de solidarisation du support à un substrat, une étape de dépôt d'au moins une couche au moins partiellement opaque dans la gamme des longueurs d'ondes de fonctionnement du composant optoélectronique et/ou électriquement conductrice sur au moins une partie des parois du trou borgne et/ou au moins une partie de la surface du support solidarisée au substrat, formant une protection optique et/ou électromagnétique.

Le support peut être formé par une seule couche, le trou borgne pouvant être obtenu par une gravure dans cette couche.

Le procédé peut comporter en outre, après l'étape d) de réalisation de l'ouverture, une étape de dépôt d'au moins une couche au moins partiellement opaque dans la gamme des longueurs d'ondes de fonctionnement du composant optoélectronique et/ou électriquement conductrice sur les parois d'une face arrière du support, opposée à la face du support solidaire du substrat.

Le procédé peut comporter en outre, après l'étape d) de réalisation de l'ouverture, une étape de report d'au moins un empilement optique comportant au moins un élément optique sur une face arrière du support, opposée à la face du support solidaire du substrat, dans un champ optique du composant optoélectronique disposé dans la cavité.

Le procédé peut comporter en outre, après l'étape de report de l'empilement optique, la réalisation de connexions électriques entre les éléments optiques de l'empilement optique et/ou de la structure de protection et/ou des composants optoélectroniques.

Le procédé peut comporter en outre la réalisation d'une protection optique et/ou électromagnétique sur l'empilement optique.

Dans ce cas, le procédé peut comporter en outre, après la réalisation de la protection optique et/ou électromagnétique, une étape de réalisation d'au moins une ouverture dans ladite protection optique et/ou électromagnétique dans le champ optique des composants optoélectroniques.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- les figures 1A et 1B représentent respectivement une vue en coupe partielle et une vue du dessus d'une structure de protection réalisée au cours d'un procédé de réalisation d'un dispositif optique, objet de la présente invention, selon un premier exemple de réalisation,

- la figure 1C représente une vue en coupe partielle d'une structure de protection réalisée au cours d'un procédé de réalisation d'un dispositif optique, objet de la présente invention, selon un second exemple de réalisation,

- la figure 2 représente une vue en coupe partielle d'un dispositif optique obtenu par la mise en oeuvre d'un procédé de réalisation, objet de la présente invention, selon un premier mode de réalisation,

- la figure 3 représente une vue en coupe partielle d'un dispositif optique obtenu par la mise en oeuvre d'un procédé de réalisation, objet de la présente invention, selon une variante du premier mode de réalisation,

- la figure 4 représente une vue en coupe partielle d'un dispositif optique obtenu par la mise en oeuvre d'un procédé de réalisation, objet de la présente invention, selon le premier mode de réalisation,

- les figures 5A, 5B et 6A à 6C représentent des vues en coupe partielle de dispositifs optiques obtenus par la mise en oeuvre de procédés de réalisation, objets de la présente invention, selon des variantes du premier mode de réalisation,

- les figures 7A à 7C représentent des vues en coupe partielle d'un dispositif optique obtenu par la mise en oeuvre de procédés de réalisation, objet de la présente invention, selon d'autres modes de réalisation,

- les figures 8A à 8G représentent des étapes de réalisation d'une structure de protection réalisée au cours d'un procédé de réalisation d'un dispositif optique, objet de la présente invention, selon un mode de réalisation particulier,

- les figures 9A à 9F représentent des étapes de réalisation d'une structure de protection réalisée au cours d'un procédé de réalisation d'un dispositif optique, objet de la présente invention, selon un autre mode de réalisation particulier,

- les figures 10A à 10K représentent des étapes d'un procédé de réalisation d'un dispositif optique, objet de la présente invention, selon un autre mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

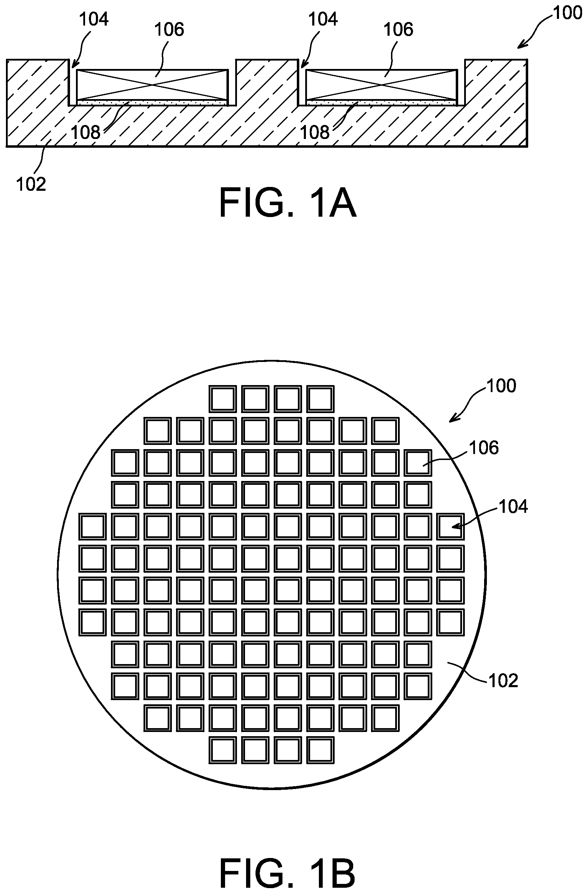

On se réfère tout d'abord aux figures 1A et 1B qui représentent respectivement une vue en coupe partielle et une vue du dessus d'une structure de protection 100, réalisée au cours d'un procédé de réalisation d'un dispositif optique à composants optoélectroniques intégrés, selon un premier exemple de réalisation.

La structure 100 comporte une couche 102 dans laquelle sont réalisés des trous borgnes 104. Sur l'exemple des figures 1A et 1B, deux trous borgnes 104 sont représentés et un élément optique 106 est solidarisé par collage dans chaque trou 104. Une interface de collage 108 entre chaque élément optique 106 et la paroi de fond de chaque trou 104 est représentée sur la figure 1A. Sur l'exemple des figures 1A et 1B, seule une partie des trous 104 et des éléments optiques 106 de la structure 100 est représentée. La structure 100 peut comporter autant de trous borgnes et d'éléments optiques que de composants optoélectroniques, par exemple ici des imageurs, intégrés dans un substrat que la structure 100 est destinée protéger. Ce substrat peut par exemple comporter plus de 1000 imageurs, ce nombre étant notamment fonction de la résolution des imageurs et de la technologie utilisée.

Les trous 104 peuvent être réalisés par lithographie et gravure DRIE (gravure ionique réactive profonde), moulage, gravure humide, sciage, découpe laser, pressage à chaud, emboutissage ou encore par micro-usinage (par exemple sablage).

Les éléments optiques 106 sont transparents dans la gamme des longueurs d'ondes de fonctionnement des imageurs du dispositif optique. Typiquement, les éléments optiques 106 peuvent être en verre et/ou en matériaux organiques (par exemple pour les imageurs fonctionnant dans la gamme des longueurs d'ondes visibles) et/ou en germanium (pour les imageurs fonctionnant dans la gamme infrarouge). Les éléments optiques 106 peuvent être des lames à faces parallèles constituées d'un matériau optiquement homogène ou être d'une géométrie permettant de réaliser des fonctionnalités optiques particulières (filtrage, grossissement, etc.) afin d'améliorer les performances de l'imageur correspondant. Les éléments optiques 106 peuvent par exemple être des lentilles.

Dans cet exemple de réalisation, la couche 102 est avantageusement à base du même matériau que celui composant le substrat comportant les imageurs destinés à être protégés par la structure 100, par exemple en semi-conducteur tel que du silicium et/ou à base de LCP. Il est également possible que la couche 102 soit à base de céramique, de matériaux organiques ou encore de métal, sans que cela pénalise le comportement thermomécanique de l'ensemble formé par la structure 100 et le substrat à imageurs après assemblage. Le matériau de la couche 102 peut notamment être choisi en fonction du matériau du substrat afin que ces matériaux aient des coefficients de dilatation thermique sensiblement similaires.

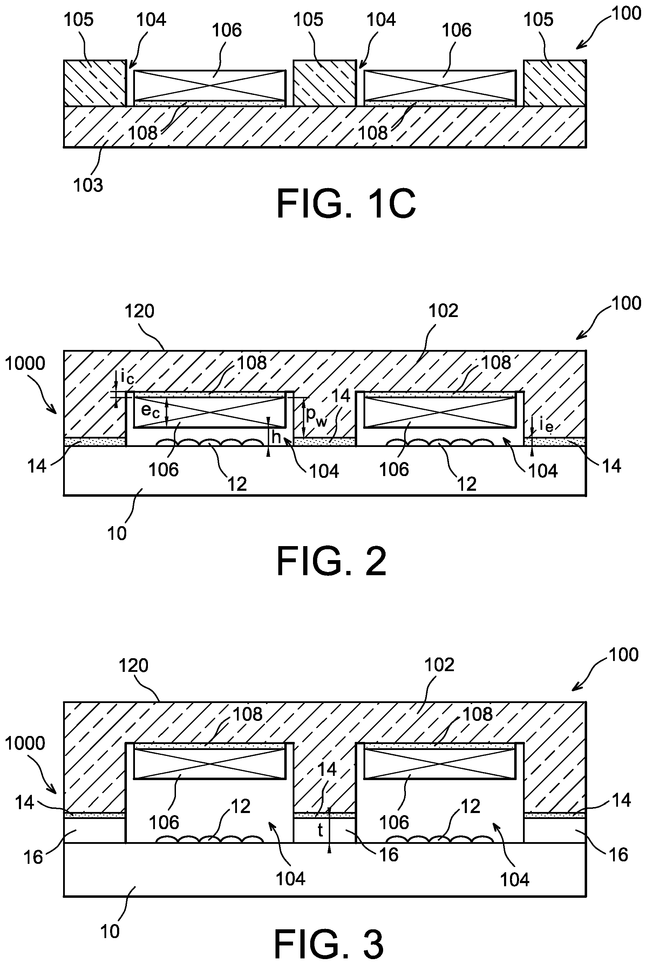

Dans l'exemple de réalisation décrit en liaison avec les figures 1A et 1B, la couche 102 est à base d'un seul matériau et les trous borgnes 104 sont formés par gravure dans la couche 102. On a donc une structure de protection formée à partir d'une seule couche « monolithique ». Dans une variante de réalisation représentée sur la figure 1C, la couche 102 peut être remplacée par un support formé par plusieurs matériaux. Sur cette figure, la structure 100 comporte un support formé par une première couche 103 sensiblement plane sur laquelle est disposée une seconde couche structurée 105. Des trous traversants sont formés dans la couche 105 afin de former les trous borgnes 104, dont les parois de fond sont formées par la première couche 103 et dans lesquels les éléments optiques 106 sont disposés, sur la couche 103 par l'intermédiaire des interfaces de collage 108. La couche 105 est avantageusement à base du même matériau que celui composant le substrat comportant les imageurs destinés à être protégés par la structure.

Dans une autre variante, il est possible que la couche ajourée 105 soit remplacée par des portions distinctes de matériau reportées sur la première couche 103, formant ainsi une structure 100 comportant les trous borgnes 104 dans lesquels sont disposés les éléments optiques 106. Ces portions reportées sur la première couche 103 peuvent avantageusement être à base du même matériau que celui composant le substrat comportant les imageurs destinés à être protégés par la structure 100.

Pour obtenir une telle structure 100, la première et la seconde couche 103, 105 peuvent être tout d'abord solidarisées par exemple par collage ou laminage. La seconde couche 105 peut également être réalisée sur la première couche 103 par dépôt PVD, CVD ou électrolytique, ou par moulage et injection-transfert. Une structuration de la seconde couche 105 pour former les trous 104 est réalisée par exemple par gravure ionique réactive profonde, moulage, injection transfert, gravure humide, sciage, découpe laser, pressage à chaud, micro-usinage ou encore co-frittage si la première et la seconde couche 103, 105 sont à base de céramique. Lorsque la seconde couche 105 est réalisée sur la première couche 103 par injection-transfert, la structuration de la seconde couche 105 peut dans ce cas se faire simultanément à sa réalisation. De manière générale, la structuration de la seconde couche 105 peut se faire avant, pendant ou après l'étape de solidarisation des deux couches 103 et 105.

Une fois que la structure 100 est réalisée, comportant le support formé par la couche 102 ou les deux couches 103 et 105, dans lequel sont disposés les éléments optiques 106, elle est reportée sur un substrat 10 comportant des imageurs 12 pour former un dispositif optique 1000, comme représenté sur la figure 2. La technique de report utilisée peut par exemple être de type collage (anodique, moléculaire, eutectique, organique, etc.) ou de type brasage par exemple à partir d'or et d'étain ou d'un autre métal et/ou alliage métallique. Sur l'exemple de la figure 2, une interface de collage 14 est présente entre la structure 100 et le substrat 10.

Après le report de la structure 100 sur le substrat 10, chaque élément optique 106 se trouve à une distance h d'un imageur 12 faisant face audit élément optique 106. Cette distance h est la distance entre le plan pixels, c'est-à-dire ici le plan à partir duquel est réalisée une détection lumineuse par les imageurs 12, et les éléments optiques 106. La valeur de cette distance h dépend de l'épaisseur $e_C$ de l'élément optique 106, de l'épaisseur $i_C$ de l'interface de collage 108, de la profondeur $p_W$ des trous 104 et de l'épaisseur $i_e$ de l'interface de collage 14. On a donc la relation :

$$h + e_C + i_C = p_W + i_e$$

Les valeurs de h, $e_C$ et $i_C$ peuvent varier d'un trou à l'autre de la structure de protection 100. La valeur de $i_e$ est directement liée à la technique de report choisie de la structure 100 sur le substrat 10. Cette cote $i_e$, et donc le choix de la technique de report utilisé, influe sur la géométrie du dispositif optique 1000. Pour une distance h désirée et une épaisseur $e_C$ de l'élément optique fixée, plus l'interface de collage 14 est épaisse, moins la profondeur du trou 104 est importante.

Sur l'exemple de la figure 2, on a $p_W > e_C + i_C$. Dans une variante, il serait possible d'avoir $p_W = e_C + i_C$ ou encore $p_W < e_C + i_C$.

La géométrie du dispositif optique 1000 peut également être liée à la topologie du substrat 10, notamment lorsque l'interface de collage 14 est décalée par rapport au plan pixels d'une distance t par des éléments espaceurs 16 disposés entre le substrat 10 et la structure 100, et sur lesquels est formée l'interface de collage 14. Un exemple d'un tel dispositif est représenté sur la figure 3. On a donc dans ce cas, la relation :

$$h + e_C + i_C = p_W + i_e + t$$

Dans cet exemple, il également possible d'avoir soit $p_W > e_C + i_C$, $p_W = e_C + i_C$ ou encore $p_W < e_C + i_C$.

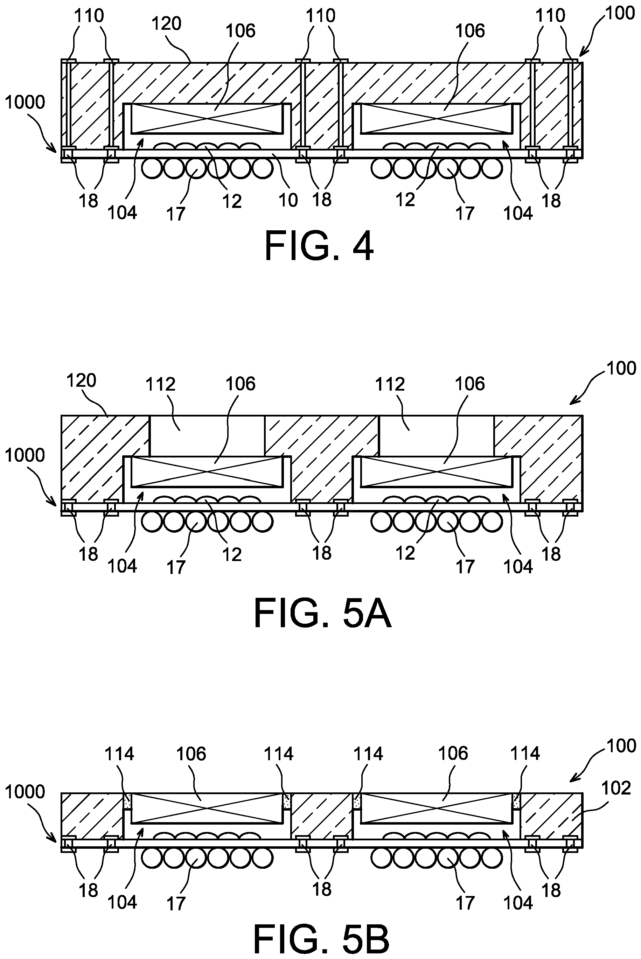

Une fois que la structure 100 est assemblée au substrat 10, différentes opérations technologiques peuvent être réalisées sur le dispositif 1000, comme cela est représenté sur la figure 4. Il est par exemple possible de réaliser un amincissement du substrat 10. La structure 100 sert alors de poignée mécanique lors de cet amincissement. Des contacts électriques 17, par exemple des microbilles de connexion, sont également formés sur la face du substrat 10 opposée à celle comportant les imageurs 12.

Sur la figure 4, on voit également que des connexions électriques 18 sont réalisées à travers le substrat 10. Ces connexions permettent de relier électriquement les deux faces principales opposées du substrat 10 et peuvent être reliées aux contacts électriques 17. Enfin, ces connexions électriques 18 sont également remontées au niveau d'une face arrière 120 de la couche 102, qui est opposée à la face de la couche 102 en contact avec le substrat 10, par des liaisons électriques 110. Une telle remontée des contacts électriques du substrat 10 peut être intéressante dans le cas où un dispositif à focale variable est destiné à être reporté ultérieurement sur la face arrière 120 de la couche 102 (applications autofocus et zoom). Ces opérations d'intraconnexions 18 et 110 sont réalisées après l'assemblage de la structure 100 au substrat 10 afin de profiter de la fonction de poignée mécanique remplie par la structure 100.

Dans les exemples des figures 2 à 4, la face arrière 120 de la couche 102 est plane. Une telle face arrière plane permet notamment de manipuler le dispositif optique 1000 avec une plus grande aisance, par exemple grâce à une aspiration plus facile de l'ensemble lorsqu'il doit être manipulé. De plus, lors de certaines opérations, un support de substrat chauffant est parfois utilisé. La présence d'une face arrière plane permet de garantir un meilleur échange thermique entre le support chauffant et le dispositif 1000, cette propriété pouvant être déterminante pour réaliser différentes opérations technologiques ultérieures à l'assemblage de la structure 100 au substrat 10.

Lorsque la couche 102, ou la première couche 103 dans le cas de la structure 100 de la figure 1C, est par exemple à base d'un matériau qui n'est pas transparent ou pas suffisamment transparent aux longueurs d'ondes émises par les imageurs 12, on réalise, après l'assemblage de la structure 100 au substrat 10 et par exemple après avoir mis en oeuvre les opérations utilisant la structure 100 pour remplir la fonction de poignée mécanique, des ouvertures dans la couche 102 permettant d'ouvrir le fond des trous borgnes 104. Un tel cas est par exemple représenté sur la figure 5A. On voit sur cette figure que des ouvertures 112 ont été réalisées dans le fond des trous 104. Ces ouvertures 112 sont réalisées dans le champ optique des éléments 106 afin que la couche 102 n'obture pas ces champs optiques. Ces ouvertures 112 peuvent, par exemple, être réalisées par lithographie et gravure.

Ces ouvertures 112 peuvent être réalisées avant la formation des contacts électriques 17 et/ou après que la plupart des opérations technologiques réalisées sur le dispositif 1000 aient été réalisées (amincissement du substrat 10, réalisation des connexions électriques 18, 110).

Il est également possible d'amincir la couche 102, à partir de la face arrière 120 de la couche 102. Cet amincissement peut être combiné avec la réalisation des ouvertures 112. Dans une variante, il est également possible d'amincir totalement la couche 102, jusqu'à atteindre les éléments optiques 106, comme cela est représenté sur l'exemple de la figure 5B. Dans cette variante, les éléments optiques 106 sont liés aux parois latérales des trous 104, c'est-à-dire les parois qui sont perpendiculaires aux parois de fond des trous 104, par des interfaces de collage 114.

Dans le cas d'un amincissement total comme représenté sur la figure 5B, il est possible d'utiliser une structure 100 telle que celle représentée sur la figure 1C, dans laquelle la première couche 103 serait collée temporairement avec la seconde couche 105. Après assemblage de la structure 100 avec le substrat 10 et éventuellement la réalisation d'étapes technologiques, la première couche 103 peut alors être désolidarisée de la seconde couche 105, permettant ainsi d'obtenir un dispositif similaire à celui représenté sur la figure 5B.

Dans une variante, les éléments optiques 106 peuvent être intégrés dans les trous 104 par un procédé d'injection d'un matériau organique, par exemple du LCP, entre l'élément optique 106 et le trou 104, ou encore par un procédé de sertissage de l'élément optique 106 dans le trou 104, évitant ainsi la présence d'une interface de collage entre l'élément optique 106 et une ou plusieurs parois du trou 104.

Le procédé de report des éléments optiques 106 dans les trous 104 peut être de type unitaire (« pick and place »), chaque élément optique 106 étant alors placé successivement dans les trous 104. Ce type de procédé de report est intéressant lorsque les éléments optiques sont réalisés de manière globale à l'échelle du substrat. Dans ce cas, un tri préalable des éléments optiques pour aboutir à un substrat ne comportant pas d'éléments optiques défectueux peut être réalisé avant d'assembler la structure 100 au substrat 10. Dans une variante, il est également possible de reporter les éléments optiques de manière collective, par exemple par un report de type DBG (« Dicing Before Grinding ») au cours duquel les éléments optiques fabriqués collectivement sont pré-découpés puis assemblés sur la couche 103 (avec la pré-découpe face à la couche 103) pour ensuite être amincis jusqu'à la singulation des éléments optiques.

Après l'assemblage de la structure 100 et du substrat 10, il est possible de découper le dispositif optique 1000 au niveau de zones pleines de la couche 102 ou au niveau des portions 105, c'est-à-dire entre les trous 104. On forme ainsi plusieurs ensembles unitaires, comportant chacun un imageur 12 et un élément optique 106. Chacun de ces ensembles unitaires peut être traité indépendamment, et par exemple être monté dans des modules caméra distincts. Toutefois, à partir de l'assemblage de la structure 100 et du substrat 10, il est également possible de réaliser complètement ou partiellement des modules caméras de manière collective à l'échelle du substrat.

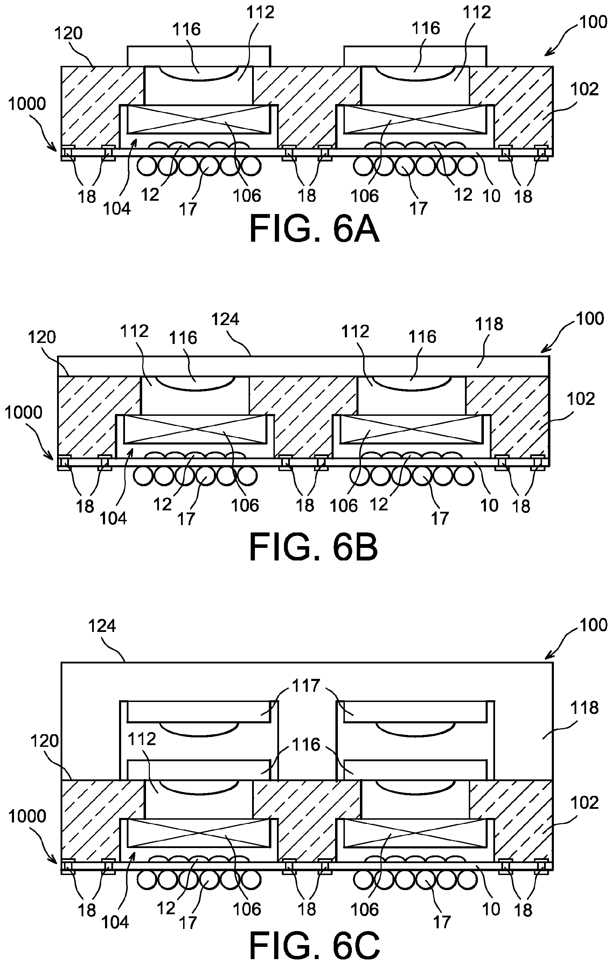

Différents éléments optiques, par exemple des lentilles, peuvent être reportés sur la face arrière 120 de la couche 102 de la structure 100. Sur le dispositif 1000 représenté sur la figure 6A, dans lequel des ouvertures 112 sont réalisées dans la couche 102 au niveau du chemin optique des imageurs 12 et des éléments optiques 106, des lentilles unitaires 116 sont disposées sur la face arrière 120 de la couche 102, au niveau des ouvertures 112. Ces lentilles 116 peuvent par exemple être disposées sur la couche 102 avant que le dispositif 1000 ne soit découpé en plusieurs éléments indépendants comportant un ou plusieurs imageurs 12, un ou plusieurs éléments optiques 106 et une ou plusieurs lentilles 116. Sur l'exemple de la figure 6A, les lentilles 116 sont insérées dans les ouvertures 112. Dans une variante représentée sur la figure 6B, un substrat 118 comportant les lentilles 116 est reporté sur toute la face arrière 120 de la couche 102, les lentilles 116 étant solidaires les unes des autres par l'intermédiaire du substrat 118. D'autres structures plus complexes peuvent être reportées sur le substrat 102, comme par exemple celle représentée sur la figure 6C, comportant un substrat 118 dans lequel sont réalisés des trous comportant plusieurs niveaux de lentilles 116, 117 (deux niveaux sur l'exemple de la figure 6C). L'exemple de la figure 6C correspond à l'exemple représenté sur la figure 6A comportant une structure de protection supplémentaire 118, par exemple similaire à une structure 100 précédemment décrite. Dans les exemples représentés sur les figures 6B et 6C, dans lesquels un substrat 118 est utilisé, il est possible de faire remonter des contacts électriques depuis le substrat 10 jusqu'à une face arrière 124 du substrat 118. Une telle opération peut être réalisée avant une ouverture du substrat 118 au niveau des lentilles 116, 117, et le report d'un ou plusieurs autres éléments optiques dans le champ optique des imageurs 12, sur la face arrière 124 du substrat 118.

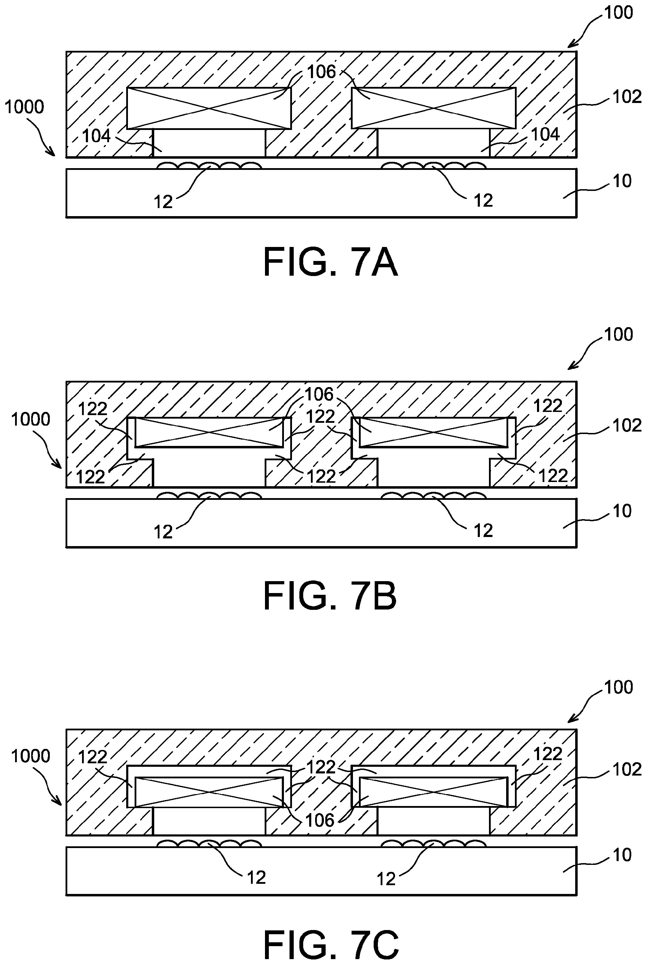

De manière générale, la géométrie de la structure 100 peut être différente de celles décrites dans les exemples précédents. Comme représenté sur la figure 7A, il est possible d'avoir des éléments optiques 106 ajustés aux dimensions des trous 104 et dont les trous 104 présentent des ouvertures optiques aux imageurs 12 de dimensions inférieures à celles des éléments optiques 106. Les figures 7B et 7C représentent des variantes de la configuration représentée sur la figure 7A, dans lesquelles des espaces vides 122 sont présents entre les parois du trou 104 et les éléments optiques 106.

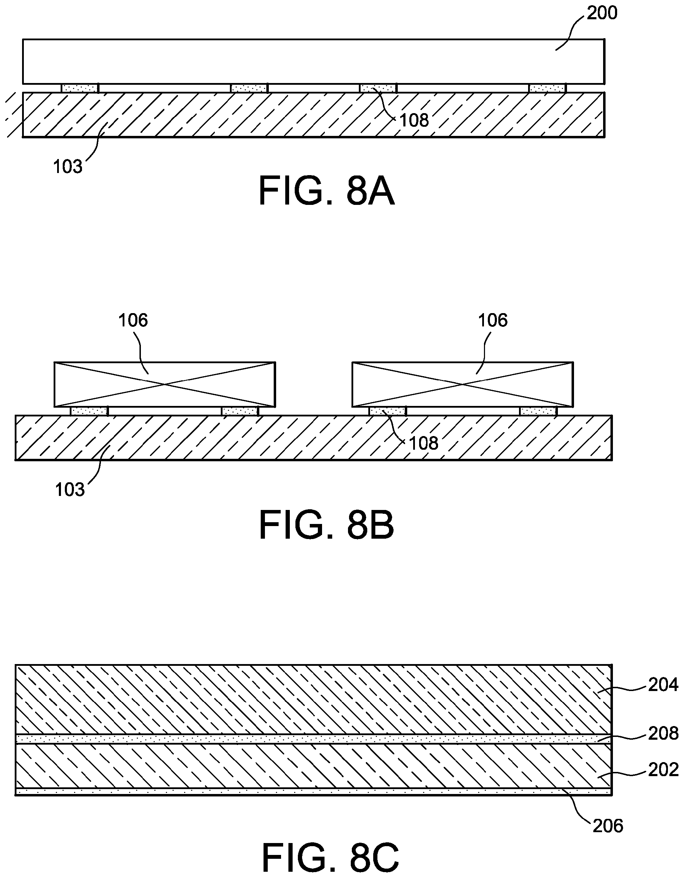

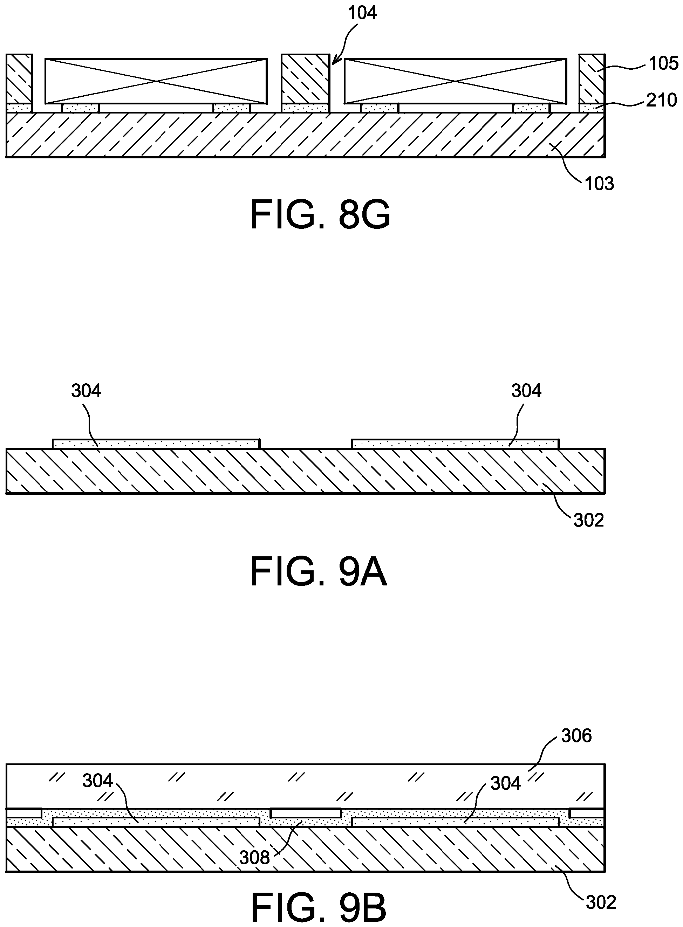

On se réfère maintenant aux figures 8A à 8G qui représentent les étapes de réalisation d'une structure de protection 100 d'un dispositif optique 1000 à composants optoélectroniques intégrés, par exemple similaire à la structure 100 représentée sur la figure 1C.

Comme représenté sur la figure 8A, afin de réaliser les éléments optiques 106, on réalise le collage d'une seconde couche 200, ici à base de verre, sur une première couche de silicium 103. Tout type de collage peut être utilisé (anodique, moléculaire, eutectique, organique). Sur l'exemple de la figure 8A, un collage organique avec des portions de résine photosensible, formant des interfaces de collage 108, est réalisé.

Une découpe ou gravure de la seconde couche 200 est ensuite réalisée afin de former les éléments optiques 106 selon les dimensions désirées (figure 8B). Cette étape peut éventuellement être réalisée en plusieurs sous-étapes de découpe.

Parallèlement à la réalisation des éléments optiques 106, on réalise la seconde partie de la structure 100, qui permettra de former la seconde couche ajourée 105.

Comme représenté sur la figure 8C, on réalise le collage d'une première couche 202 de semi-conducteur, par exemple du silicium, à une seconde couche 204 de semi-conducteur, également du silicium dans cet exemple. Dans cet exemple de réalisation, la première couche 202 comporte des faces oxydées, formant des couches de $SiO_2$ 206, 208, permettant de réaliser un collage moléculaire silicium/$SiO_2$ solidarisant les deux couches 202, 204. Il est également possible que ce soit la seconde couche 204 qui comporte des faces oxydées, et non la première couche 202, permettant également de réaliser un collage moléculaire silicium/$SiO_2$ solidarisant les deux couches 202, 204.

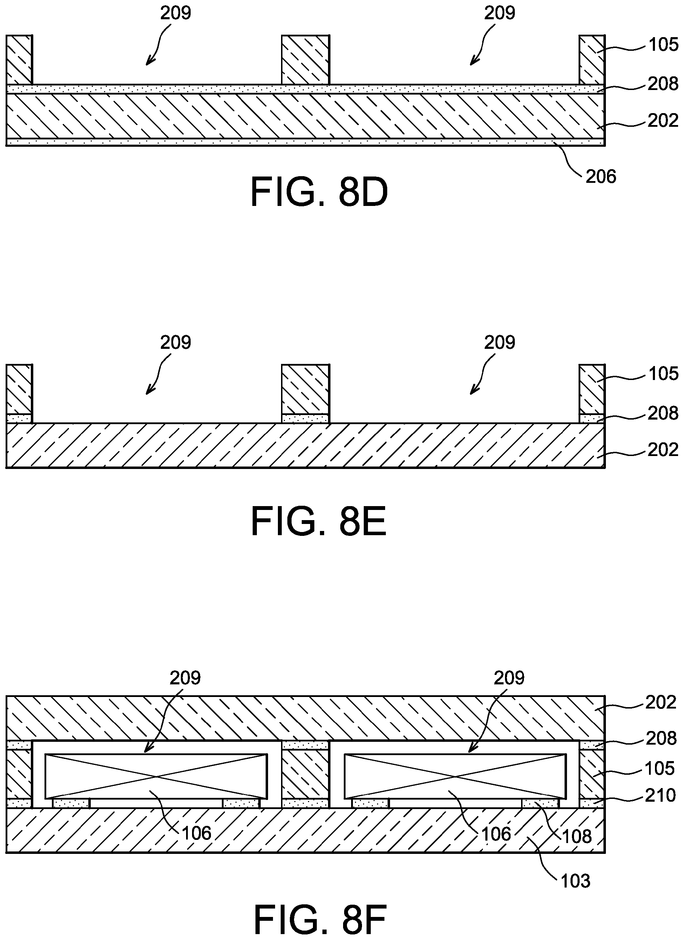

Sur la figure 8D, on réalise ensuite des étapes de lithographie et gravure de trous 209 dans la seconde couche 204 avec arrêt sur la couche de $SiO_2$ 208, les portions restantes formant ainsi la seconde couche structurée 105 destinée à être reportée sur la couche 103. Dans une variante, au moins une couche mince supplémentaire interposée entre les deux couches 202, 204 pourrait également faire office de couche d'arrêt de gravure. On réalise ensuite une gravure du diélectrique présent sur la structure, c'est-à-dire les portions de la couche diélectrique de $SiO_2$ 208 non recouverte par la seconde couche structurée 105 et la couche de $SiO_2$ 206, par exemple une gravure humide à base d'une solution de HF (figure 8E). Dans une variante, il est également possible de ne pas graver le diélectrique présent sur la structure.

On réalise ensuite l'assemblage des deux parties de la structure de protection 100 préalablement réalisées, par exemple par un collage tel qu'un collage organique par epoxy 210 (figure 8F).

Enfin, on réalise un amincissement total de la couche 202 et la suppression des portions restantes de la couche de $SiO_2$ 208, permettant ainsi d'obtenir une structure de protection 100 similaire à celle représentée sur la figure 1C.

Afin d'obtenir des structures de protection dans lesquelles les éléments optiques 106 sont ajustés aux dimensions des trous 104 et dont les trous 104 présentent des ouvertures optiques aux imageurs 12 de dimensions inférieures à celles des éléments optiques 106, comme dans les exemples représentés sur les figures 7A à 7C, il est possible de ne pas réaliser un amincissement total de la couche 202. Après l'étape de collage représentée sur la figure 8F, on peut réaliser alors un amincissement partiel de la couche 202, puis une lithographie et une gravure locale de la couche 202 afin de réaliser des ouvertures dans la couche 202 au niveau des éléments optiques 106.

On se réfère maintenant aux figures 9A à 9F qui représentent les étapes d'une variante de réalisation de la structure de protection 100 d'un dispositif optique 1000.

On réalise tout d'abord une structure similaire à celle représentée sur la figure 8E comportant la couche 202, la seconde couche structurée 105 et les portions diélectriques 208 (ou les couches diélectriques 206 et/ou 208 lorsque le diélectrique n'est pas gravé). Cette structure est par exemple réalisée de manière similaire au procédé précédemment décrit en mettant en oeuvre les étapes décrites en liaison avec les figures 8C à 8E. La couche 202 est ici destinée à former la première couche 103 de la structure de protection 100.

Les exemples de réalisation décrits ici comportent des interfaces de collage des éléments optiques structurés tels qu'aucun interface de collage ne se trouve dans le champ optique des éléments optiques 106. Toutefois, au cours du procédé de réalisation de la structure de protection 100, il est possible d'avoir des portions de colle présentes dans le champ optique des éléments 106, ces portions pouvant être conservées jusqu'au bout du procédé, même après l'ouverture du champ optique des éléments 106 dans la mesure où ces portions présentent des propriétés optiques adéquates, ou bien gravées au cours du procédé, après l'ouverture du champ optique des éléments 106. Il est donc possible de conserver le diélectrique et/ou les interfaces de collage dans le champ optique des éléments 106. Si toutefois, le diélectrique dégrade les performances optiques, le diélectrique et/ou les interfaces de collage peuvent être retirés au moment de la réalisation de la structure de protection ou éventuellement à la fin du procédé de réalisation du dispositif optique 1000, lors d'une ouverture de la structure de protection au niveau du champ optique des éléments optiques 106.

Comme représenté sur la figure 9A, on réalise le dépôt de portions de résine photosensible 304 sur une couche 302 à base de verre ou de semi-conducteur. Ces portions de résine photosensible 304 sont déposées au niveau des futurs emplacements des éléments optiques 106.

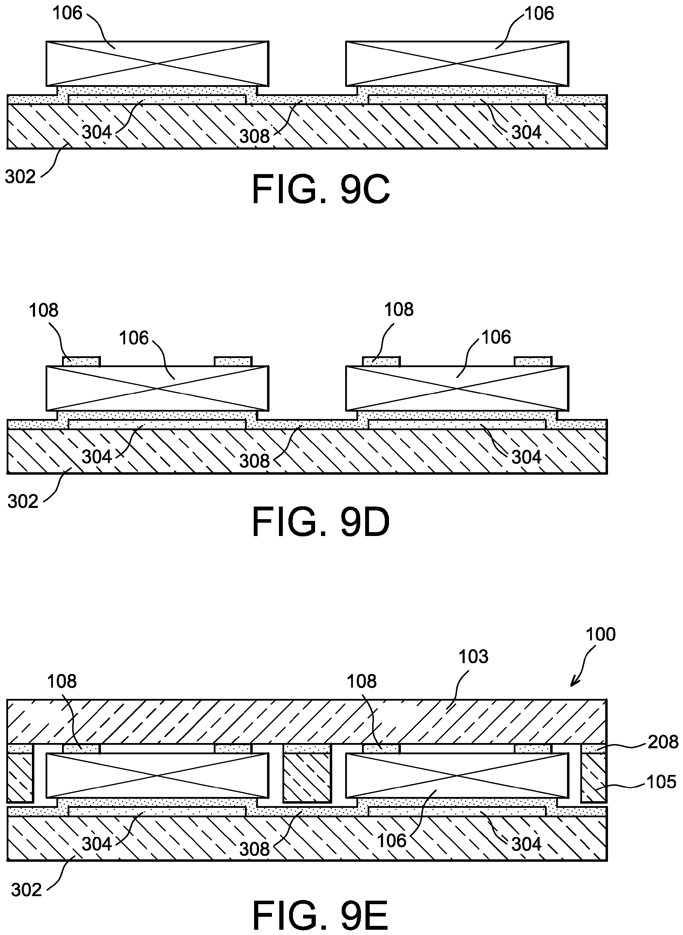

On réalise ensuite un collage temporaire d'une seconde couche à base de verre 306, à partir de laquelle vont être réalisés les éléments optiques 106, par l'intermédiaire d'une interface de collage 308, sur la première couche 302 et les portions de résine 304 (figure 9B). La seconde couche de verre 306 est alors découpée afin de former les éléments optiques 106 (figure 9C).

Des portions de résine photosensible (film sec laminé par exemple) sont déposées sur les éléments optiques 106, formant les portions d'interfaces 108 (figure 9D). Ces portions de résine permettront de réaliser ultérieurement un collage organique des éléments optiques 106. Il est également possible de déposer ces portions d'interface par sérigraphie.

Sur la figure 9E, on réalise ensuite l'assemblage entre les deux structures précédemment réalisées, par l'intermédiaire des portions d'interface 108 et de la première couche 103, dans les creux formés dans la seconde couche 105.

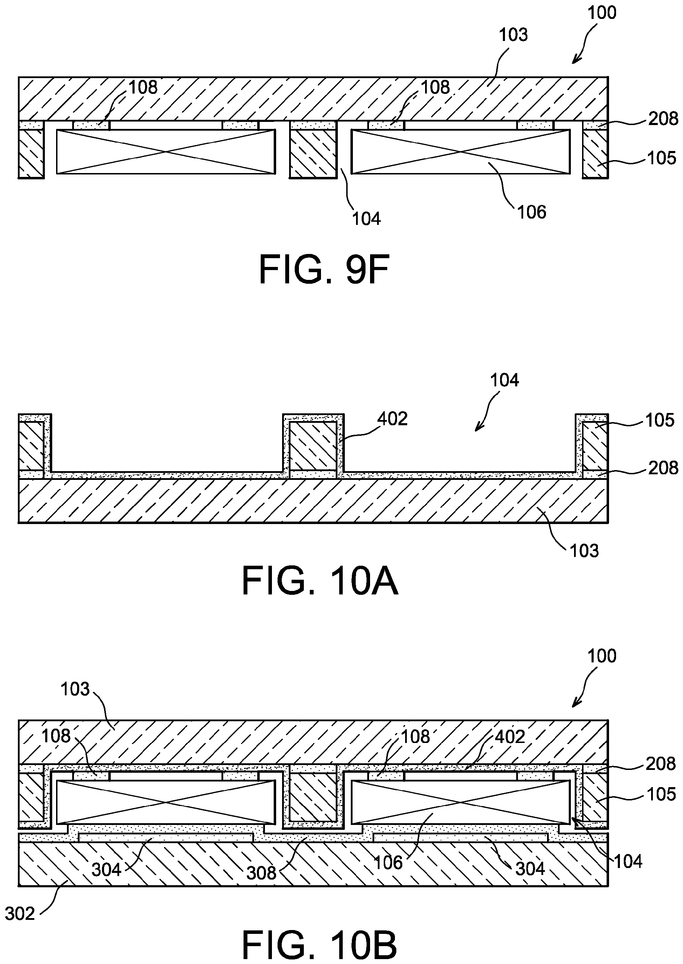

Enfin, sur la figure 9F, la couche 302, les portions de résine 304 et la couche de collage temporaire 308 sont retirées, permettant ainsi d'obtenir la structure 100.

De part la structure de protection utilisée, il est possible que cette structure réalise également la protection des imageurs vis-à-vis de la lumière parasite, c'est-à-dire de la lumière se trouvant hors du champ optique des imageurs, et/ou de perturbations électromagnétiques liées à l'environnement de fonctionnement du dispositif optique 1000 comportant les imageurs (par exemple dans un téléphone portable).

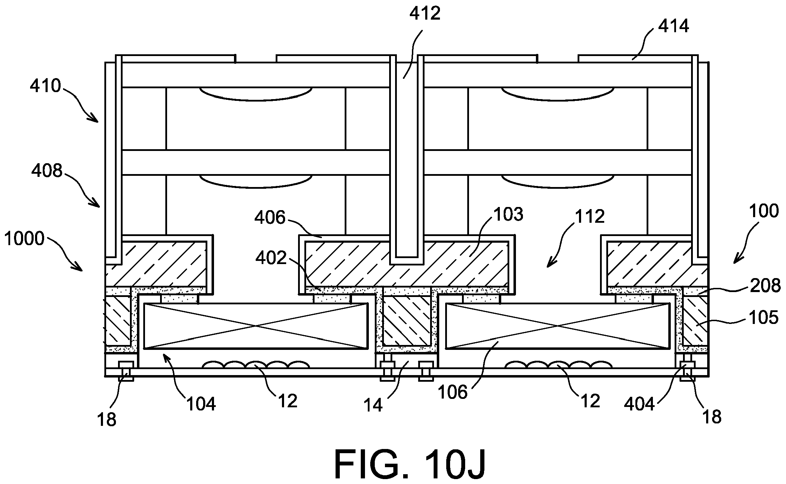

Un procédé de réalisation d'un dispositif optique comportant une telle structure de protection va maintenant être décrit en liaison avec les figures 10A à 10K.

On réalise tout d'abord une structure similaire à celle représentée sur la figure 8E comportant la couche 202, la seconde couche structurée 105 et les portions diélectrique 208, afin de former une première partie de la structure 100. Cette structure est par exemple réalisée de manière similaire au premier mode de réalisation, en mettant en oeuvre les étapes décrites en liaison avec les figures 8C à 8E. La couche 202 est ici destinée à former la première couche 103 de la structure de protection 100.

Comme représenté sur la figure 10A, on dépose ensuite une ou plusieurs couches 402 sur la face de la structure précédemment réalisée présentant les trous 104, recouvrant ainsi les portions de la seconde couche 105 et la face de la première couche 103 formant les parois de fond des trous 104. La couche 402 peut être opaque ou au moins partiellement opaque dans la gamme des longueurs d'ondes des imageurs destinés à être protégés par cette structure 100 et/ou électriquement conductrice. Il est également possible de réaliser le dépôt d'une première couche 402 opaque et le dépôt d'une seconde couche 402 électriquement conductrice sur la première couche 402 opaque ou inversement.

On met ensuite en oeuvre les étapes précédemment décrites en liaison avec les figures 9A à 9D afin de former une seconde partie de la structure 100 comportant la couche 302, les portions de résine 304, l'interface de collage 308, les éléments optiques 106 et les portions d'interface 108.

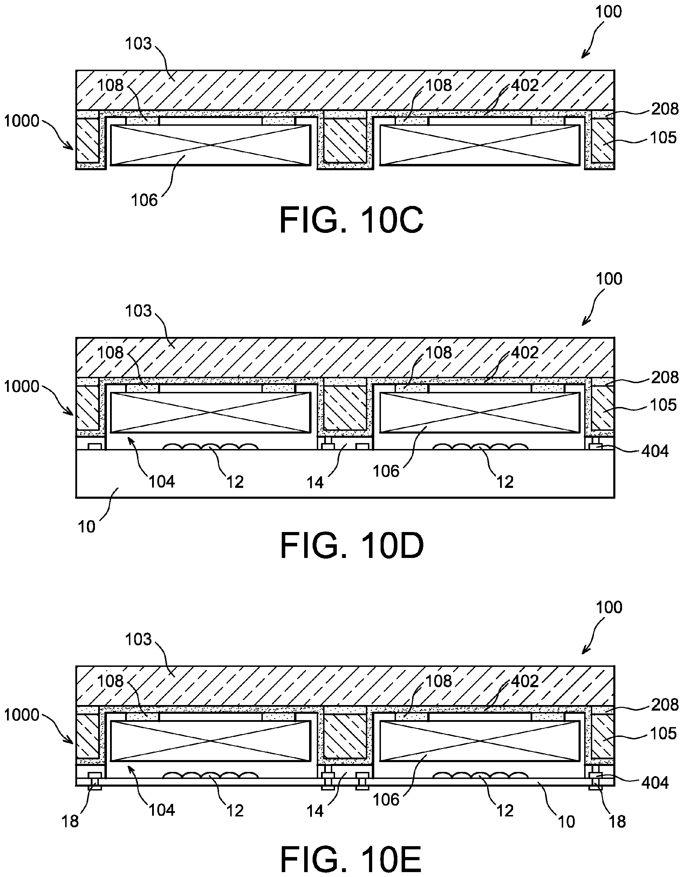

Sur la figure 10B, on réalise ensuite l'assemblage entre les deux structures précédemment réalisées, par l'intermédiaire des portions d'interface 108 et de la première couche 103, dans les trous 104. Sur la figure 10C, le substrat 302, les portions de résine 304 et la couche de collage temporaire 308 sont retirés, permettant ainsi d'obtenir la structure 100.

Comme représenté sur la figure 10D, on réalise ensuite l'assemblage entre la structure de protection 100 précédemment réalisée et le substrat 10 comportant des imageurs 12 intégrés pour former le dispositif optique 1000. Dans cet exemple de réalisation, des portions de colle organique opaque 14 sont utilisées pour réaliser cet assemblage (colle électriquement isolante). Préalablement à cet assemblage, des contacts 404 ont été réalisés sur le substrat 10, au niveau des portions de colle 14, tel que l'on ait au moins un contact 404 par imageur 12.

Sur la figure 10E, on réalise ensuite un amincissement du substrat 10 puis on forme des interconnexions 18 dans le substrat 10 dont une partie est reliée aux contacts 404. Ces interconnexions 18 reliées aux contacts 404 permettent de réaliser une reprise de masse en face arrière du dispositif 1000.

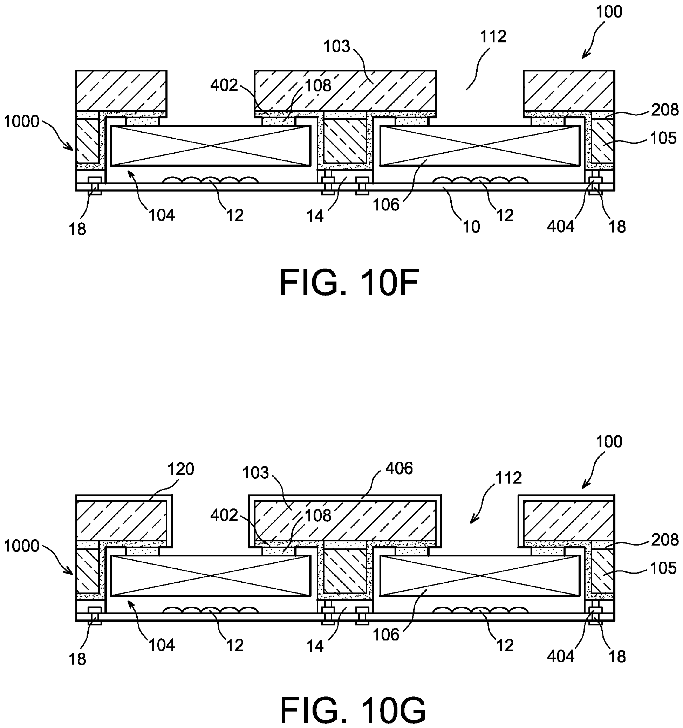

On réalise ensuite des ouvertures 112 dans la première couche 103 afin de libérer le champ optiques des imageurs 106 (figure 10F).

Comme représenté sur la figure 10G, on dépose ensuite une ou plusieurs couches 406 sur les parois de la couche 103. La couche 406 peut être opaque dans la gamme des longueurs d'ondes des imageurs destinés à être protégés par cette structure 100 et/ou électriquement conductrice. Il est également possible de réaliser le dépôt d'une première couche 406 opaque et le dépôt d'une seconde couche 406 électriquement conductrice sur la première couche 406 opaque ou inversement.

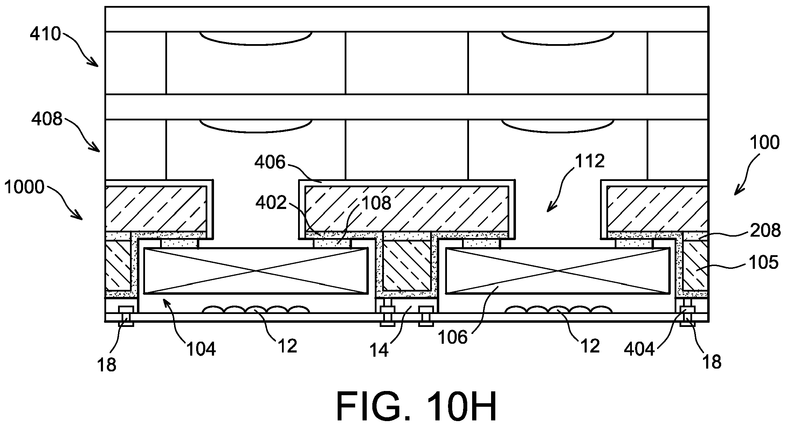

Enfin, on peut réaliser des niveaux optiques supplémentaires, comme représenté sur la figure 10H, sur laquelle deux autres niveaux 408 et 410 sont représentés, chaque niveau comportant des éléments optiques (lentilles, lames à faces parallèles, etc.) disposés dans le champ optique des imageurs 12.

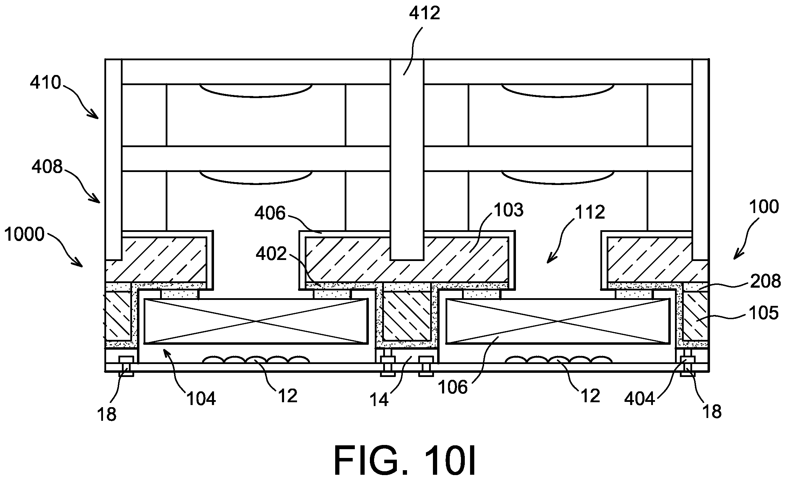

Sur la figure 10I, on réalise une découpe partielle du dispositif 1000, formant des tranchées 412 traversant complètement les niveaux optiques supplémentaires 408, 410, mais ne traversant que partiellement la première couche 103, afin que les autres éléments intacts du dispositif 1000 puissent garantir la tenue mécanique du dispositif 1000.

On réalise ensuite un dépôt métallique opaque 414 sur le dispositif 1000 et notamment sur les parois des tranchées 412, permettant de définir l'ouverture du dispositif 1000 au niveau du champ optique et de reprendre le contact électrique avec la couche 106.

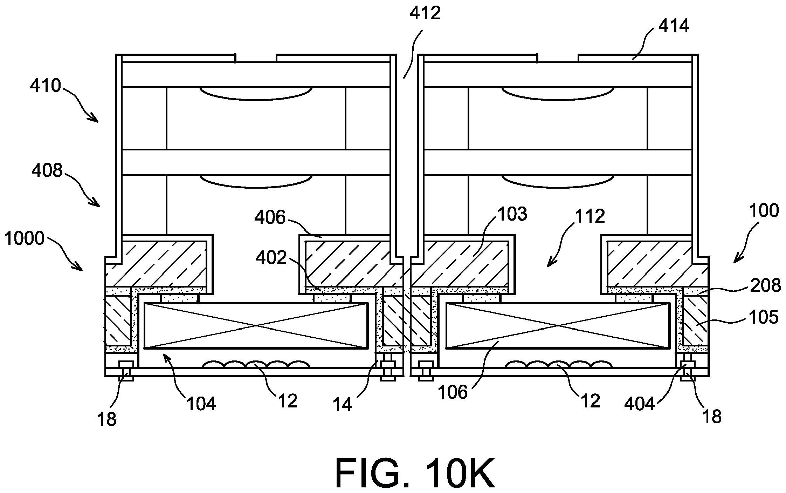

Le procédé est ensuite achevé par la réalisation de billes d'interconnexions 17 sous chaque imageur 12 et par la singulation de chaque portion du dispositif 1000 comportant au moins un imageur 12 (figure 10K) afin de former différents modules caméra.

Le dispositif 1000 réalisé selon le procédé décrit en liaison avec les figures 10A à 10K permet de garantir une tenue mécanique même après une découpe partielle du dispositif 1000, tout en assurant une protection optique et électromagnétique aux imageurs 12. Cette fonction de protection décrite peut également être assurée par la structure proposée dans le cas où des interconnexions entre la structure et le substrat imageur sont réalisées.

La géométrie des éléments optiques 106 n'est pas forcément similaire à celle des imageurs 12 au niveau de leurs plans pixels, qui est par exemple de forme rectangulaire. Les éléments optiques 106 peuvent être de forme rectangulaire ou d'une toute autre forme (carré, circulaire, etc.) et/ou avoir un facteur de forme similaire ou différent de celui des imageurs.

Bien entendu, de nombreuses variantes de réalisation peuvent être appliquées. En particulier, toutes les réalisations des cavités dans un support peuvent être utilisées dans le cadre de l'invention. On peut citer notamment le procédé de type DBG dans lequel un prédécoupage avant report puis un amincissement sont réalisés pour obtenir des cavités borgnes.

## Revendications

**1.** Procédé de réalisation d'un dispositif optique (1000) à composants optoélectroniques intégrés (12), comportant au moins les étapes de :

a) réalisation d'une structure de protection (100) comprenant au moins un support dans lequel est réalisé au moins un trou borgne (104), au moins un élément optique (106) étant disposé dans le trou borgne (104) et solidarisé avec au moins une paroi du trou borgne (104), puis
b) solidarisation du support à un substrat (10) comprenant les composants optoélectroniques (12) intégrés, le trou borgne (104) formant une cavité dans laquelle l'élément optique (106) fait face à un des composants optoélectroniques (12), puis
c) réalisation d'un amincissement du substrat (10) en utilisant le support comme poignée mécanique et réalisation de connexions électriques (18) à travers le substrat (10), puis
d) réalisation d'au moins une ouverture (112) à travers la paroi de fond du trou borgne (104), découvrant au moins une partie du champ optique de l'élément optique (106).

**2.** Procédé selon la revendication 1, comportant en outre, au cours de l'étape c), la réalisation de connexions électriques (110, 404) entre le substrat (10) et le support et/ou à travers le support, et/ou la réalisation d'un amincissement du support.

**3.** Procédé selon l'une des revendications précédentes, dans lequel l'élément optique (106) est à base de verre et/ou d'un matériau organique et/ou de germanium.

**4.** Procédé selon l'une des revendications précédentes, dans lequel l'élément optique (106) comporte au moins une lame à faces parallèles et/ou une lentille et/ou une lentille à gradient d'indice.

**5.** Procédé selon l'une des revendications précédentes, dans lequel le support comporte une face arrière (120), opposée à une face destinée à être solidarisée au substrat (10), sensiblement plane.

**6.** Procédé selon l'une des revendications précédentes, dans lequel les composants optoélectroniques intégrés comportent des imageurs CMOS et/ou CCD.

**7.** Procédé selon l'une des revendications précédentes, dans lequel le support est à base d'un matériau ayant un coefficient de dilatation thermique sensiblement similaire à celui du matériau du substrat (10) .

**8.** Procédé selon l'une des revendications précédentes, dans lequel, lors de l'étape b), le support est solidarisé au substrat par l'intermédiaire d'éléments espaceurs.

**9.** Procédé selon l'une des revendications précédentes, l'étape d) correspondant à la mise en oeuvre d'un amincissement du support.

**10.** Procédé selon l'une des revendications précédentes, l'étape a) de réalisation de la structure de protection (100) correspondant à la mise en oeuvre des étapes suivantes :

- réalisation d'un premier empilement comportant une première couche mécanique (103) et une seconde couche (200) à base d'au moins un matériau formant l'élément optique (106),
- gravure de la seconde couche (200), au moins une portion restante de la seconde couche (200) formant l'élément optique (106),
- réalisation d'un second empilement comportant une troisième couche (202) et une quatrième couche (204),
- gravure d'au moins un trou (209) à travers la quatrième couche (204),
- solidarisation des premier et second empilements, des portions restantes (105) de la quatrième couche (204) étant disposées contre une face de la première couche (103), l'élément optique (106) étant disposé dans le trou (209) gravé à travers la quatrième couche (204),
- retrait de la troisième couche (202).

**11.** Procédé selon la revendication 10, dans lequel le retrait de la troisième couche (202) est obtenu par une étape d'amincissement total de la troisième couche (202) ou un démontage de la troisième couche (202) lorsque celle-ci est solidarisée par un collage temporaire à la quatrième couche (204).

**12.** Procédé selon l'une des revendications 1 à 9, l'étape a) de réalisation de la structure de protection (100) correspondant à la mise en oeuvre des étapes suivantes :

- réalisation d'un premier empilement comportant une première couche (302) et une seconde couche (306) à base d'au moins un matériau formant l'élément optique (106),
- gravure de la seconde couche (306), au moins une portion restante de la seconde couche (306) formant l'élément optique (106),
- dépôt d'une interface de collage (108) au moins sur l'élément optique (106),
- réalisation d'un second empilement comportant une troisième couche mécanique (103) et une quatrième couche,
- gravure d'au moins un trou à travers la quatrième couche,
- solidarisation des premier et second empilement, la troisième couche (103) étant disposée contre l'interface de collage (108), l'élément optique (106) étant disposé dans le trou gravé à travers la quatrième couche,
- retrait de la première couche (302).

**13.** Procédé selon l'une des revendications 1 à 9, l'étape a) de réalisation de la structure de protection (100) comportant au moins les sous-étapes suivantes :

- réalisation du support dans lequel est réalisé le trou borgne (104),
- positionnement et solidarisation de l'élément optique (106) dans le trou borgne (104) par l'intermédiaire d'au moins un matériau de fixation (108) préalablement disposé au moins sur une paroi du trou borgne (104) et/ou sur l'élément optique (106).

**14.** Procédé selon l'une des revendications précédentes, comportant en outre, entre l'étape a) de réalisation de la structure de protection (100) et l'étape b) de solidarisation du support à un substrat (10), une étape de dépôt d'au moins une couche (402) au moins partiellement opaque dans la gamme des longueurs d'ondes de fonctionnement du composant optoélectronique (12) et/ou électriquement conductrice sur au moins une partie des parois du trou borgne (104) et/ou au moins une partie de la surface du support solidarisée au substrat (10), formant une protection optique et/ou électromagnétique.

**15.** Procédé selon l'une des revendications 1 à 13, comportant en outre, au cours de l'étape a), la réalisation d'une protection optique (402) et/ou électromagnétique entre le support et l'élément optique (106) .

**16.** Procédé selon l'une des revendications 1 à 9 et 13 à 15, le support étant formé par une seule couche (102), le trou borgne (104) étant obtenu par une gravure dans cette couche (102).

**17.** Procédé selon l'une des revendications précédentes, comportant en outre, après l'étape d) de réalisation de l'ouverture (112), une étape de dépôt d'au moins une couche (406) au moins partiellement opaque dans la gamme des longueurs d'ondes de fonctionnement du composant optoélectronique (12) et/ou électriquement conductrice sur les parois d'une face arrière (120) du support, opposée à la face du support solidaire du substrat (10).

**18.** Procédé selon l'une des revendications précédentes, comportant en outre, après l'étape d) de réalisation de l'ouverture (112), une étape de report d'au moins un empilement optique (408, 410) comportant au moins un élément optique sur une face arrière (120) du support, opposée à la face du support solidaire du substrat (10), dans un champ optique du composant optoélectronique (12) disposé dans la cavité.

**19.** Procédé selon la revendication 18, comportant en outre, après l'étape de report de l'empilement optique (408, 410), la réalisation de connexions électriques entre les éléments optiques (106) de l'empilement optique (408, 410) et/ou de la structure de protection (100) et/ou des composants optoélectroniques (12).

**20.** Procédé selon l'une des revendications 18 ou 19, comportant en outre la réalisation d'une protection optique et/ou électromagnétique (414) sur l'empilement optique (408, 410).

**21.** Procédé selon la revendication 20, comportant en outre, après la réalisation de la protection optique et/ou électromagnétique (414), une étape de réalisation d'au moins une ouverture dans ladite protection optique et/ou électromagnétique (414) dans le champ optique des composants optoélectroniques (12) .

**Patentansprüche**

**1.** Verfahren zur Herstellung einer optischen Vorrichtung (1000) mit integrierten optoelektronischen Komponenten (12), umfassend wenigstens die folgenden Schritte:

a) Herstellen einer Schutzstruktur (100), umfassend wenigstens einen Träger in dem ein Blindloch (104) hergestellt ist, wobei wenigstens ein optisches Element (106) in dem Blindloch (104) angeordnet und mit wenigstens einer Wand des Blindlochs (104) verbunden ist, dann

b) Verbinden des Trägers mit einem Substrat (10), das integrierte optoelektronische Komponenten (12) umfasst, wobei das Blindloch (104) einen Hohlraum bildet, in dem das optische Element (106) einer der optoelektronischen Komponenten (12) gegenüber liegt, dann

c) Herstellen einer Abdünnung des Substrats (10) unter Verwendung des Trägers als mechanischer Griff und Herstellen von elektrischen Verbindungen (18) durch das Substrat (10) hindurch, dann

d) Herstellen wenigstens einer Öffnung (112) durch die Bodenwand des Blindlochs (104) hindurch, wobei wenigstens ein Teil des Sichtfelds des optischen Elements (106) freigelegt wird.

2. Verfahren nach Anspruch 1, ferner umfassend im Verlauf des Schritts c) die Herstellung von elektrischen Verbindungen (110, 404) zwischen dem Substrat (10) und dem Träger und/oder durch den Träger hindurch und/oder die Herstellung einer Abdünnung des Trägers.

3. Verfahren nach einem der vorhergehenden Ansprüche, wobei das optische Element (106) auf Basis von Glas und/oder eines organischen Materials und/oder von Germanium ist.

4. Verfahren nach einem der vorhergehenden Ansprüche, wobei das optische Element (106) wenigstens einen Streifen mit parallelen Flächen und/oder eine Linse und/oder eine Linse mit einem Indexgradienten umfasst.

5. Verfahren nach einem der vorhergehenden Ansprüche, wobei der Träger eine im Wesentlichen ebene Rückfläche (120) umfasst, die einer Fläche entgegengesetzt ist, die mit dem Substrat (10) verbunden werden soll.

6. Verfahren nach einem der vorhergehenden Ansprüche, wobei die integrierten optoelektronischen Komponenten CMOS- und/oder CCD-Bildgeber umfassen.

7. Verfahren nach einem der vorhergehenden Ansprüche, wobei der Träger auf Basis eines Materials ist, das einen thermischen Ausdehnungskoeffizienten im Wesentlichen ähnlich jenem des Substratmaterials (10) hat.

8. Verfahren nach einem der vorhergehenden Ansprüche, wobei während des Schritts b) der Träger mit dem Substrat mittels Abstandshalterelementen verbunden wird.

9. Verfahren nach einem der vorhergehenden Ansprüche, wobei der Schritt d) der Durchführung einer Abdünnung des Trägers entspricht.

10. Verfahren nach einem der vorhergehenden Ansprüche, wobei der Schritt a) der Herstellung der Schutzstruktur (100) der Durchführung der folgenden Schritte entspricht:

- Herstellen eines ersten Stapels, umfassend eine erste mechanische Schicht (103) und eine zweite Schicht (200) auf Basis wenigstens eines Materials, das das optische Element (106) bildet,
- Ätzen der zweiten Schicht (200), wobei wenigstens ein verbleibender Bereich der zweiten Schicht (200) das optische Element (106) bildet,
- Herstellen eines zweiten Stapels, umfassend eine dritte Schicht (202) und eine vierte Schicht (204),
- Ätzen wenigstens eines Lochs (209) durch die vierte Schicht (204) hindurch,
- Verbinden des ersten und des zweiten Stapels, wobei verbleibende Bereiche (105) der vierten Schicht (204) gegen eine Fläche der ersten Schicht (103) angeordnet sind, wobei das optische Element (106) in dem Loch (209) angeordnet ist, das durch die vierte Schicht (204) hindurch geätzt ist,
- Entfernen der dritten Schicht (202).

11. Verfahren nach Anspruch 10, wobei das Entfernen der dritten Schicht (202) durch einen Schritt einer vollständigen Abdünnung der dritten Schicht (202) oder eine Demontage der dritten Schicht (202) erhalten wird, wenn diese durch eine zeitweilige Verklebung mit der vierten Schicht (204) verbunden ist.

12. Verfahren nach einem der Ansprüche 1 bis 9, wobei der Schritt a) der Herstellung der Schutzstruktur (100) der Durchführung der folgenden Schritte entspricht:

- Herstellen eines ersten Stapels, umfassend eine erste Schicht (302) und eine zweite Schicht (306) auf Basis wenigstens eines Materials, das das optische Element (106) bildet,
- Ätzen der zweiten Schicht (306), wobei wenigstens ein verbleibender Bereich der zweiten Schicht (306) das optische Element (106) bildet,
- Aufbringen einer Verklebungsgrenzfläche (108) wenigstens auf das optische Element (106),
- Herstellen eines zweiten Stapels, umfassend eine dritte mechanische Schicht (103) und eine vierte Schicht,

- Ätzen wenigstens eines Lochs durch die vierte Schicht hindurch,

- Verbinden des ersten und des zweiten Stapels, wobei die dritte Schicht (103) gegen die Verklebungsgrenzfläche (108) angeordnet ist, wobei das optische Element (106) in dem Loch angeordnet ist, das durch die vierte Schicht hindurch geätzt ist,

- Entfernen der ersten Schicht (302).

13. Verfahren nach einem der Ansprüche 1 bis 9, wobei der Schritt a) der Herstellung der Schutzstruktur (100) wenigstens die folgenden Unterschritte umfasst:

- Herstellen des Trägers, in dem das Blindloch (104) hergestellt ist,

- Positionieren und Verbinden des optischen Elements (106) in dem Blindloch (104) mittels wenigstens eines Befestigungsmaterials (108), das zuvor wenigstens auf einer Wand des Blindlochs (104) und/oder auf dem optischen Element (106) angeordnet wird.

14. Verfahren nach einem der vorhergehenden Ansprüche, ferner umfassend zwischen dem Schritt a) der Herstellung der Schutzstruktur (100) und dem Schritt b) der Verbindung des Trägers mit einem Substrat (10) einen Schritt des Aufbringens wenigstens einer Schicht (402), die wenigstens teilweise opak ist in dem Wellenlängenbereich des Betriebs der optoelektronischen Komponente (12) und/oder elektrisch leitend ist, auf wenigstens einem Teil der Wände des Blindlochs (104) und/oder wenigstens einem Teil der Oberfläche des Trägers, der mit dem Substrat (10) verbunden ist, zur Bildung eines optischen und/oder elektromagnetischen Schutzes.

15. Verfahren nach einem der Ansprüche 1 bis 13, ferner umfassend im Verlauf des Schritts a) die Herstellung eines optischen und/oder elektromagnetischen Schutzes (402) zwischen dem Träger und dem optischen Element (106).

16. Verfahren nach einem der Ansprüche 1 bis 9 und 13 bis 15, wobei der Träger durch eine einzige Schicht (102) gebildet ist, wobei das Blindloch (104) durch ein Ätzen in dieser Schicht (102) erhalten wird.

17. Verfahren nach einem der vorhergehenden Ansprüche, ferner umfassend nach dem Schritt d) der Herstellung der Öffnung (112) einen Schritt des Aufbringens wenigstens einer Schicht (406), die wenigstens teilweise opak ist in dem Wellenlängenbereich des Betriebs der optoelektronsichen Komponente (12) und/oder elektrisch leitend ist, auf den Wänden einer Rückfläche (120) des Trägers, die der Fläche des Trägers entgegengesetzt ist, die mit dem Substrat (10) verbunden ist.

18. Verfahren nach einem der vorhergehenden Ansprüche, ferner umfassend nach dem Schritt d) der Herstellung der Öffnung (112) einen Schritt der Übertragung wenigstens eines optischen Stapels (408, 410), umfassend wenigstens ein optisches Element auf einer Rückfläche (120) des Trägers, die der Fläche des Trägers entgegengesetzt ist, die mit dem Substrat (10) verbunden ist, in ein Sichtfeld der optoelektronischen Komponente (12), die in dem Hohlraum angeordnet ist.

19. Verfahren nach Anspruch 18, ferner umfassend nach dem Schritt der Übertragung des optischen Stapels (408, 410) die Herstellung von elektrischen Verbindungen zwischen den optischen Elementen (106) des optischen Stapels (408, 410) und/oder der Schutzstruktur (100) und/oder den optoelektronischen Komponenten (12).

20. Verfahren nach einem der Ansprüche 18 oder 19, ferner umfassend die Herstellung eines optischen und/oder elektromagnetischen Schutzes (414) auf dem optischen Stapel (408, 410).

21. Verfahren nach Anspruch 20, ferner umfassend nach der Herstellung des optischen und/oder elektromagnetischen Schutzes (414) einen Schritt der Herstellung wenigstens einer Öffnung in dem optischen und/oder elektromagnetischen Schutz (414) im Sichtfeld der optoelektronischen Komponenten (12).

**Claims**

1. A method for making an optical device (1000) with integrated optoelectronic components (12), including at least the steps of:

a) making a protective structure (100) comprising at least one support in which at least one blind hole (104) is made, at least one optical element (106) being positioned in this blind hole (104) and firmly attached to at least one wall of the blind hole (104), then

b) firmly attaching the support to a substrate (10) comprising the integrated optoelectronic components (12), the blind hole (104) forming a cavity in which the optical element (106) faces one of the optoelectronic components (12), then

c) performing thinning of the substrate (10) and making electric connections (18) through the substrate (10), then

d) making at least one aperture (112) through the bottom wall of the blind hole (104), uncovering at least one portion of the optical field of the optical element (106).

2. The method according to claim 1, further including, during step c), the making of electric connections (110, 404) between the substrate (10) and the support and/or through the support, and/or the achievement of thinning of the support.

3. The method according to any of the preceding claims, wherein the optical element (106) comprises glass and/or an organic material and/or germanium.

4. The method according to any of the preceding claims, wherein the optical element (106) includes at least one plate with parallel faces and/or one lens and/or one lens with an index gradient.

5. The method according to any of the preceding claims, wherein the support includes a rear face (120), opposite to a face intended to be firmly attached to the substrate (10), substantially planar.

6. The method according to any of the preceding claims, wherein the integrated optoelectronic components include CMOS and/or CCD imagers.

7. The method according to any of the preceding claims, wherein the support comprises a material having a heat expansion coefficient substantially similar to the one of the material of the substrate (10).

8. The method according to any of the preceding claims, wherein, during step b), the support is firmly attached to the substrate via spacer elements.

9. The method according to any of the preceding claims, the step d) corresponding to the application of thinning to the support.

10. The method according to any of the preceding claims, the step a) for making the protective structure (100) corresponding to the application of the following steps:

   - making a first stack including a first mechanical layer (103) and a second layer (200) comprising at least one material forming the optical element (106),
   - etching the second layer (200), at least one remaining portion of the second layer (200) forming the optical element (106),
   - making a second stack including a third layer (202) and a fourth layer (204),
   - etching at least one hole (209) through the fourth layer (204),
   - firmly attaching the first and second stacks, remaining portions (105) of the fourth layer (204) being positioned against a face of the first layer (103), the optical element (106) being positioned in the hole (209) etched through the fourth layer (204),
   - removing the third layer (202).

11. The method according to claim 10, wherein removal of the third layer (202) is obtained by a step for totally thinning the third layer (202) or disassembling the third layer (202) when the latter is firmly attached by a temporary adhesive bonding to the fourth layer (204).

12. The method according to any of claims 1 to 9, the step a) for making the protective structure (100) corresponding to the application of the following steps:

   - making a first stack including a first layer (302) and a second layer (306) comprising at least one material forming the optical element (106),
   - etching the second layer (306), at least one remaining portion of the second layer (306) forming the optical element (106),
   - depositing an adhesive bonding interface (108) on at least the optical element (106),
   - making a second stack including a third mechanical layer (103) and a fourth layer,
   - etching at least one hole through the fourth layer,
   - firmly attaching the first and second stacks, the third layer (103) being positioned against the adhesive bonding interface (108), the optical element (106) being positioned in the hole etched through the fourth layer,
   - removing the first layer (302).

13. The method according to any of claims 1 to 9, the step a) for making the protective structure (100) including at least the following sub-steps:

   - making the support in which the blind hole (104) is made,
   - positioning and firmly attaching the optical element (106) in the blind hole (104) via at least one attachment material (108) positioned beforehand at least on one wall of the blind hole (104) and/or on the optical element (106).

14. The method according to any of the preceding claims, further including, between step a) for making the protective structure (100) and the step b) for firmly attaching the support to a substrate (10), a step for depositing at least one layer (402), at least partly opaque in the range of the operating wavelengths of the optoelectronic component (12) and/or electrically conducting on at least one part of the walls of the blind hole (104) and/or at least one part of the surface of the support firmly attached to the substrate (10), forming an optical and/or electromagnetic protection.

15. The method according to any of claims 1 to 13, further including, during step a), the making of an optical and/or electromagnetic protection (402) between the support and the optical element (106).

16. The method according to any of claims 1 to 9 and 13 to 15, the support being formed by a single layer (102), the blind hole (104) being obtained by etching in this layer (102).

17. The method according to any of the preceding claims, further including, after step d) for making the aperture (112), a step for depositing at least one layer (406) at least partly opaque in the range of the operating wavelengths of the optoelectronic component (12) and/or electrically conducting on the walls of a rear face (120) of the support, opposite to the face of the support firmly attached to the substrate (10).

18. The method according to any of the preceding claims, further including, after step d) for making the aperture (112), a step for transferring at least one optical stack (408, 410) including at least one optical element on a rear face (120) of the support, opposite to the face of the support firmly attached to the substrate (10), in an optical field of the optoelectronic component (12) positioned in the cavity.

19. The method according to claim 18, further including, after the step for transferring the optical stack (408, 410), the making of electric connections between the optical element (106) of the optical stack (408, 410) and/or of the protective structure (100) and/or of the optoelectronic components (12).

20. The method according to any of claims 18 or 19, further including the making of an optical and/or electromagnetic protection (414) on the optical stack (408, 410).

21. The method according to claim 20, further including, after making the optical and/or electromagnetic protection (414), a step for making at least one aperture in said optical and/or electromagnetic protection (414) in the optical field of the optoelectronic components (12).

FIG. 1A

FIG. 1B

## FIG. 1C

## FIG. 2

## FIG. 3

FIG. 4

FIG. 5A

FIG. 5B

FIG. 6A

FIG. 6B

FIG. 6C

FIG. 7A

FIG. 7B

FIG. 7C

FIG. 8A

FIG. 8B

FIG. 8C

209       209       105

208

202

206

# FIG. 8D

209       209       105

208

202

# FIG. 8E

209       209       202

208

105

210

106       106    108

103

# FIG. 8F

104

105

210

103

## FIG. 8G

304                    304

302

## FIG. 9A

306

304                    304

308

302

## FIG. 9B

FIG. 9C

FIG. 9D

FIG. 9E

FIG. 9F

FIG. 10A

FIG. 10B

FIG. 10C

FIG. 10D

FIG. 10E

EP 2 279 524 B1

FIG. 10F

FIG. 10G

FIG. 10H

FIG. 10I

EP 2 279 524 B1

FIG. 10J

EP 2 279 524 B1

FIG. 10K

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7223626 B2
- US 2006035415 A1
- US 2006043262 A1
- US 7144745 B2
- US 5915168 A
- US 2005275750 A1